# EUROPEAN PATENT SPECIFICATION

(11) **EP 0 526 567 B1**
(45) Date of publication and mention of the grant of the patent: **19.03.1997**
(21) Application number: 91909111.6
(22) Date of filing: 25.04.1991
(51) Int. Cl.: B41F 3/38, C08G 59/18, C08G 59/40, C08G 59/68, B41N 1/22, G03F 7/038

(54) **A ROTOGRAVURE PRINTING MEDIA AND METHODS OF MANUFACTURING A ROTOGRAVURE PRINTING DEVICE EMPLOYING THE MEDIA**
TIEFDRUCKPLATTENMATERIAL UND VERFAHREN ZUR HERSTELLUNG EINER TIEFDRUCKVORRICHTUNG UNTER VERWENDUNG DIESES MATERIALS
SUPPORTS D'IMPRESSION POUR ROTOGRAVURES ET PROCEDES DE FABRICATION D'UN DISPOSITIF D'IMPRESSION PAR ROTOGRAVURE EMPLOYANT LES SUPPORTS

(30) Priority: 26.04.1990 US 514595
(43) Date of publication of application: 10.02.1993
(73) Proprietor: W.R. CHESNUT ENGINEERING, INC., Fairfield, NJ 07006 (US)
(72) Inventor: BRESSLER, David, E., Chester, NJ 07930 (US); CALIGARO, Daniel, Little Falls, NJ 07424 (US); CHESNUT, W., Richard, Essex Fells, NJ 07021 (US)
(74) Representative: LOUIS, PÖHLAU, LOHRENTZ & SEGETH
(86) International application number: US9102870
(87) International publication number: WO9116200

(56) References cited:
- EP-A- 0 094 142
- GB-A- 1 544 748
- US-A- 2 052 679
- US-A- 2 305 224
- US-A- 2 931 297
- US-A- 3 294 889
- US-A- 4 007 680
- US-A- 4 036 130
- US-A- 4 048 035
- US-A- 4 060 656
- US-A- 4 198 739
- US-A- 4 256 828
- US-A- 4 593 051
- US-A- 4 738 899
- US-A- 5 027 513

## Description

This invention relates to a printing medium upon a substrate such as a printing roll or a cylinder. More particularly, this invention relates to the application of a plastic printing media to printing rolls or cylinders employed in rotogravure printing.

Rotogravure printing is one of the conventional methods of printing on a sheet, web, or other substrate. The sheet or substrate may be a coated, uncoated, or metallized paper; glassine; plastic films and sheets made from vinyl, cellulose, acetate, polyester and polyethylene; plastic shrink films; paperboard,; aluminum foil, and fabrics. Rotogravure printing is capable of reproducing both subtle shades of color and black and white, and is particularly well suited for printing great numbers of copies precisely and rapidly. Typical end uses include labels, cartons, paper and plastic cups, trading stamps, wrapping paper, and sheet vinyl flooring.

Rotogravure printing is the only commercial printing process which can control both the ink film thickness and the area of coverage. This is achieved by the engraving of recessed microscopic wells, frequently referred to as "cells" of varying depth and area in the printing medium or image carrier surface. In controlling the size and depth of the wells, the amount of ink available for placement on the substrate is governed to generate an image composed of an arrangement of large and small dots.

In a typical rotogravure apparatus, the printing medium or image carrier is a copper film electro-deposited from a chemical bath on a specially prepared steel cylinder.

Prior to the engraving of the recessed wells, the copper is mechanically ground and polished. After engraving, the cylinder requires the addition of plated, hard chromium for durability and wear resistance. During the printing process the cylinder is rotated in a bath of ink. The excess ink is wiped away by a doctor blade and the ink remaining in the engraved cell is then transferred to a substrate, with the substrate acting somewhat like a blotter to which the ink is transferred as discrete dots as the substrate passes between the engraved cylinder and a soft pressure roller.

The recommended modern process to prepare a copper image carrier requires the use of electrolytic deposition from an acid/copper bath. A steel base of the required diameter is partly immersed in a chemical copper solution and rotated at a regulated speed. An electrical current running through the solution gradually deposits a coating of copper on the rotating cylinder until the approximate required thickness is achieved. The copper plated cylinder is washed and then polished to final dimensions with a smooth, mirror like surface finish.

The copper coating is then engraved, either chemically or electronically. In the chemical engraving process, wells are formed by acid etching of the copper coating. The wells of the cell are formed by a screen running at right angles which prevents the acid from reaching the copper surface. The resulting acid-etched wells are round in shape and slightly smaller at the bottom than at the top.

The process of forming the copper coating for the printing cylinder and of chemically engraving the copper coating may result in the formation of waste products which are environmentally hazardous, requiring costly disposal.

GB-A- 1 544 748 discloses a gravure printing method according to which a gravure printing base plate is uniformely covered with a layer of polymeric materials. Examples of the disclosed polymeric materials include polyvinyl chloride, polyamide resin, polyester and polycarbonate.

EP-A- 0 094 142 relates to a print member with a surface of an epoxy novolac resin. The surface is generally prepared by powder coating the substrate, fusing the plastic particles, and then heat curing the resin.

According to US-A- 4,007,680 an epoxy resin is used as printing surface, the epoxy resin being gellable at room temperature.

US-A- 3,294,889 discloses a coating for rotogravure printing cylinders as printing surfaces consisting of a photosensitized polymeric material and an additional layer of an epoxy-type resin.

Finally, US-A- 4,060,656 discloses a composition for use in making a printing plate, the composition consisting, inter alia, of an epoxy compound and a photopolymerizable compound so that curing of the composition can be effected by ultraviolet radiation.

In accordance with an aspect of the present invention, there is provided a printing medium for application to a printing apparatus (e.g., a rotogravure printing drum or cylinder). The term "printing apparatus", as used herein, means any apparatus or device which transfers an inked image. The medium comprises a plastic composition which is applied to a substrate to form a plastic coating covering the printing substrate, which plastic coating is engraved to provide a printing surface.

According to the present invention, the plastic composition which is applied to the substrate may be a mixture of an expanding polycyclic monomer such as a spiroorthocarbonate or spiroorthoester, formed with a combination of a diepoxy oligomer such as a diglycidylether, and a lactone in a concentration of from about 1:2.5 to about 1:4.5 by weight of the oligomer. To this mixture there may be added a catalytic quantity of a boron trihalide-amine complex and a catalytic quantity of an aromatic photocatalyst which releases a carbonium ion upon ultraviolet irradiation. After the printing medium is applied to the substrate, the printing medium may be cured by ultraviolet light and/or by heating. Alternatively, a di- or tri- functional acrylate may be added to the initial mixture. Preferably, the expanding monomer is a spiroorthoester formed in situ by the reaction of a lactone such as γ-butyrolactone or γ-caprolactone with an epoxide. The expanding monomer may also be a polycyclic ring system, wherein the rings are opened during polymerization. The diepoxy oligomer may be bisphenol-A diglycidyl ether. The aromatic photocatalyst may be a triphenyl sulfonuim flexafluoro antimonate (eg., FX-512 as hereinabove described), or arsenate, or phosphate. The Lewis acid tertiary amine complex catalyst may be selected from boron trichloride N,N' - dimethyl piperazine salt, boron trifluoride monoethylamine salt, orthophenylene diamine-boron trifluoride salt, or a 4,4' diamine diphenylsulfone-boron trichloride salt.

The plastic composition may also include a fluorocarbon sulfonic acid salt, which is employed as a flow aid. Examples of such plastic compositions containing the hereinabove described expanding polycyclic monomers and catalysts are further described in U. S. Patent No. 4,738,899. A commercially available example of such a plastic composition is sold as EP222003, by Epolin, Inc., of Newark, New Jersey. This product has a viscosity at room temperature of from about 2,000 to about 4,000 cP, and a specific gravity of 1.1.

The plastic composition may be applied to the printing substrate by various means well known in the art. The method of the present invention is particularly applicable to the application of the plastic composition as a liquid to a printing roll or cylinder which is employed in a rotogravure printing process. The printing roll or cylinder may be made of aluminum, steel, or plastic.

Prior to the application of the plastic composition to the printing roll or cylinder, the printing roll or cylinder may be pretreated by means of a plasma or corona pretreatment to clean and/or alter the surface (i. e., lower the surface tension) of the cylinder or roll for improved film or coating wetout and bonding strengths.

When a corona pretreatment of the surface of the printing roll or cylinder is employed, the surface of the printing roll or cylinder is treated with an accurately-directed electrical bombardment of the surface of the printing roll or cylinder to clean and/or alter the surface of the printing roll or cylinder. An example of such a corona pretretment is the Tantec HV05 System, as sold by Tampo Print America Inc., of Schaumburg, Illinois.

When an aluminum printing cylinder is employed, the surface may be pretreated so as to provide an anodized surface. When a steel cylinder is employed, the cylinder may be treated with an oxide such as black oxide, or may be treated so as to provide an iridited surface.

Methods of applying the plastic composition include spraying the composition onto the surface of the printing substrate such as the printing roll or cylinder. Such spraying may be accomplished through the use of a nozzle through techniques known in the art. Other methods which may be employed include dip coating, spin coating, and ring coating.

Upon application of the raw plastic composition to the substrate, it is cured so as to form a plastic coating covering the substrate, said coating now capable of being etched to provide a printing surface. Methods of curing include, but are not limited to, ultraviolet irradiation (which may be followed by heating), heating, and gelation at room temperature. The method employed to cure the composition depends upon the particular plastic composition applied to the printing substrate.

After the plastic coating is applied to the substrate and cured, it is engraved so as to provide a printing medium or image carrier. The engraving may be accomplished by any of various engraving methods known in the art: however, a preferred method of engraving is electronic engraving. Electronic engraving may, in one embodiment, be carried out using a diamond stylus which has an included angle of from about 110° to about 130°. The narrower the included angle, the deeper the stylus cuts into the plastic coating. As the stylus cuts into the coating, it forms a plurality of wells in the coating. Each well has an angled wall, and is smaller at the bottom than at the top.

In one embodiment, the reliability of electronic engraving can be enhanced by employing an air knife device to aid in the removal of chips away from the support, or foot, of the diamond stylus. The air knife dispenses a precise, focused, and continuous or pulsed air stream. The air stream moves in a direction opposite that of the movement of the cylinder. The air stream directs chips away from the support, or foot, of the diamond stylus, the cutting diamond, and the burr cutter in a direction toward a vacuum device, whereby the chips may be removed from the printing surface by the vacuum device located in the cutting head.

In one embodiment, prior to engraving, the plastic coating may be contacted (preferably by spraying) with a finely divided fluropolymer as a dry film lubricant for the plastic coating. The dry film lubricant provides for lubrication of the support, or foot, of the diamond stylus as the stylus traverses the plastic coating during the engraving. Such lubrication provides for improved penetration of the surface of the plastic coating by the diamond stylus and provides for increased life of the diamond stylus. A preferred finely divided fluorpolymer powder is a micronized tetrafluoroethylene powder. An example of such a micronized tetrafluoroethylene powder is sold by DuPont, Wilmington, Delaware, as Vydax.

Once the printing medium or image carrier is formed on the substrate, it is ready for the application of printing ink. Examples of gravure type inks which may be applied to the printing medium include aliphatic hydrocarbon inks such as A-Type inks and B-Type inks; nitrocellouse inks (C-Type); polyamide inks (D-Type); alcohol-based inks (E-Type); polystyrene-based inks (M-Type); chlorinated rubber-based inks (T-Type); vinyl chloride or vinyl acetate copolymer-based inks (V-Type); inks employing water as a solvent base (W-Type); X-Type inks including heat transfer and sublimation inks; and foam inks. The type of ink employed depends upon the type of surface that is to be printed. Upon application of the ink, any excess ink is removed by a doctor blade. It has been found that a doctor blade formed from a polymer such as polyester, nylon, polyethylene, polypropylene, or polyacetal, and having a tapered edge which contacts the printing medium, conditions the image-bearing surface without substantial wear and is a great improvement over metal doctor blades employed in the art with copper-etched surfaces. Most preferably, a polyester doctor blade is employed for removing the excess ink. Examples of polyester doctor blades having a tapered edge which may be employed in accordance with the present invention are those of Esterlam's E350/E500 range of laminated polyester doctor blades, sold by Esterlam International Limited, of Devon, England.

Thus, in accordance with another aspect of the present invention, there is provided a process for preparing a non-metal printing medium for the transfer of an inked image which comprises applying ink to the printing medium, and removing excess ink from the printing medium by contacting the printing medium with a doctor blade, having a tapered edge, said doctor blade being formed from a polymer selected from the group consisting of polyester, nylon, polyethylene, polypropylene and polyacetal to prepare thereby the printing medium for the transfer of an inked image. Preferably, the doctor blade is formed from a polyester.

Upon application of the ink, the printing medium and printing substrate are then ready to print any of a wide variety of materials which may be printed by the rotogravure process.

Advantages of the present invention include the ability to provide a printing medium or image carrier upon a printing substrate such as a printing cylinder or printing roll which does not require the use and/or disposal of environmentally hazardous chemicals during its preparation. The method of the present invention, whereby a plastic composition, as opposed to a metal, is applied to a printing substrate, thus provides for a more efficient and environmentally safe process for providing a rotogravure printing medium, which also saves the considerable costs associated with the formation and treatment of copper-etched surfaces.

It is to be understood, however, that the scope of the present invention is not to be limited to the specific embodiments described above. The invention may be practiced other than as particularly described and still be within the scope of the accompanying claims.

## Claims

1. A rotogravure printing apparatus which comprises a rotogravure printing drum which is coated with a plastic composition, said plastic composition including a mixture of an expanding polycyclic monomer, said expanding polycyclic monomer being selected from the group consisting of a spiroorthocarbonate and a spiroorthoester, said monomer being formed with the combination of diglycidylether and a lactone in a concentration of from about 1:2.5 to about 1:4.5 by weight of the diglycidylether.

## Patentansprüche

1. Vorrichtung für den Rotationstiefdruck mit einer Rotationstiefdrucktrommel, die mit einer Kunststoffzusammensetzung beschichtet ist, wobei die Kunststoffzusammensetzung eine Mischung eines expandierenden polycyclischen Monomers einschließt und das expandierende polycyclische Monomer aus der aus einem Spiroorthocarbonat und einem Spiroorthoester bestehenden Gruppe ausgewählt ist, wobei das Monomer durch die Kombination von Diglycidylether und einem Lacton in einer Konzentration von etwa 1:2,5 bis etwa 1:4,5 bezogen auf das Gewicht des Diglycidylethers gebildet wird.

## Revendications

1. Un appareil d'impression pour rotogravure qui comprend un tambour d'impression pour rotogravure recouvert d'une composition plastique, ladite composition plastique étant composée d'un mélange d'un monomère polycyclique expandable, ledit monomère polycyclique expandable étant sélectionné à partir d'un groupe consistant en un spiroorthocarbonate et un spiroorthoester, ledit monomère étant formé d'une combinaison de diglycidyléther et d'un lactone en concentration d'environ 1 : 2,5 à environ 1 : 4,5 du poids dudit diglycidyléther.
